(19) Europäisches Patentamt
European Patent Office
Office européen des brevets

(11) **EP 3 787 050 B1**

(12) **FASCICULE DE BREVET EUROPEEN**

(45) Date de publication et mention
de la délivrance du brevet:
**13.12.2023 Bulletin 2023/50**

(21) Numéro de dépôt: **20193436.1**

(22) Date de dépôt: **28.08.2020**

(51) Classification Internationale des Brevets (IPC):
***H10N 70/00*** *(2023.01)*

(52) Classification Coopérative des Brevets (CPC):
**H10N 70/801; H10N 70/24; H10N 70/245;
H10N 70/826; H10N 70/8833;** H10B 63/80

(54) **DISPOSITIF MÉMOIRE NON-VOLATILE DE TYPE FILAMENTAIRE**

NICHT-FLÜCHTIGE SPEICHERVORRICHTUNG VOM TYP FILAMENT

FILAMENT TYPE NON-VOLATILE MEMORY DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.08.2019 FR 1909570**

(43) Date de publication de la demande:
**03.03.2021 Bulletin 2021/09**

(73) Titulaires:
• **Commissariat à l'Energie Atomique et aux
Energies
Alternatives
75015 Paris (FR)**
• **Université Grenoble Alpes
38401 Saint-Martin-d'Hères (FR)**
• **Centre National de la Recherche Scientifique
75016 Paris (FR)**

(72) Inventeurs:
• **NAVARRO, Gabriele
38054 GRENOBLE CEDEX 09 (FR)**
• **GUILLAUME, Nicolas
38054 GRENOBLE CEDEX 09 (FR)**
• **BLONKOWSKI, Serge
38240 MEYLAN (FR)**
• **GONON, Patrice
38120 SAINT-EGREVE (FR)**
• **JALAGUIER, Eric
38054 GRENOBLE CEDEX 09 (FR)**

(74) Mandataire: **Cabinet Camus Lebkiri
25 rue de Maubeuge
75009 Paris (FR)**

(56) Documents cités:
**US-A1- 2005 243 596    US-A1- 2011 103 131
US-A1- 2011 248 381    US-A1- 2014 029 327**

**Description**

**DOMAINE TECHNIQUE**

Le domaine technique est, d'une façon générale, celui de la micro-électronique, plus précisément celui des dispositifs mémoire non volatile de type filamentaire.

**ARRIERE-PLAN TECHNOLOGIQUE**

De nouveaux types de mémoires non volatiles, appelées mémoires résistives, ou parfois ReRAM (selon l'acronyme anglo-saxon de Resistive Random Access Memory), ont été développés ces dernières années. Comme pour toute mémoire non-volatile, les informations logiques enregistrées dans la mémoire restent stockées dans celle-ci, sans s'effacer, lorsque la mémoire est mise hors-tension. Dans une mémoire résistive, ces informations logiques, binaires, sont représentées par des niveaux de résistance, soit haut, soit bas, de différentes cellules résistives contenues dans la mémoire.

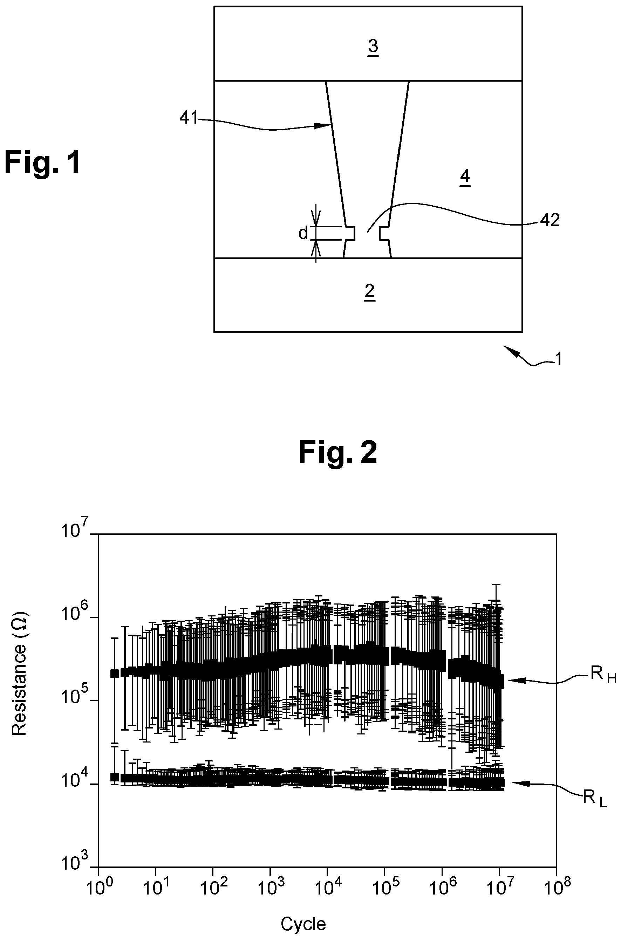

Une cellule résistive de type filamentaire comprend plus précisément une couche active 4 prise entre deux électrodes conductrices 2 et 3 (voir la figure 1, qui représente schématiquement une telle cellule mémoire, en coupe). Dans la couche active 4, un filament 41 électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé, et de RESET, lorsque le filament est rompu à nouveau). La couche active 4 est essentiellement isolante, sauf au niveau du filament en question.

Dans une mémoire de type filamentaire à oxyde, parfois appelée OxRam (selon l'acronyme anglo-saxon de « Oxide Random Access Memory »), la couche active 4 est formée plus précisément d'un oxyde de métal, par exemple un oxyde de Tantale ou d'Hafnium. Et dans une mémoire de type filamentaire à conduction ionique, parfois appelée CB-RAM (selon l'acronyme anglo-saxon de « Conductive Bridge Random Access Memory »), en général, la couche active 4 est constituée d'un électrolyte solide dans lequel des cations métalliques peuvent être relocalisés et réduits pour former le filament conducteur.

La fabrication d'une mémoire filamentaire comprend une étape dite de « forming », au cours de laquelle le filament est formé pour la première fois dans la couche active, initialement dépourvue de filament. Pour cela, une tension électrique est appliquée entre les première et deuxième électrodes de la cellule mémoire 1 considérée. La valeur de cette tension est augmentée jusqu'à ce que le filament 41 conducteur se forme dans la couche active 4. Dans certains cas, l'étape de « forming » est plutôt réalisée en injectant un courant électrique contrôlé dans l'une des électrodes de la cellule mémoire, la valeur de ce courant étant augmentée progressivement jusqu'à ce que le filament conducteur se forme. Plus généralement, l'étape de « forming » est réalisée en pilotant la tension et/ou le courant appliqués à la cellule mémoire, selon un cycle de pilotage prédéterminé.

Après cette étape de « forming », la cellule mémoire 1 est prête à l'usage. Le filament 41 conducteur peut alors être rompu, puis reformé, puis rompu à nouveau et ainsi de suite. Pour rompre le filament 41, ou pour le reformer, on fait varier la tension électrique appliquée entre les électrodes et/ou le courant électrique injecté dans l'une de ces électrodes, selon un cycle prédéterminé.

Dans l'état bassement résistif de la cellule mémoire 1, le filament conducteur, qui s'étend de part en part à travers la couche conductrice, de manière ininterrompue, a une résistance électrique basse, $R_L$. Et dans l'état hautement résistif de la cellule mémoire 1, le filament, qui est rompu, de sorte que la cellule mémoire présente une résistance électrique haute, $R_H$.

Sur la figure 2, on a représenté les valeurs médianes des résistances basse et haute du filament, RL et RH, obtenues au cours de 10 millions cycles successifs d'écriture puis de remise à zéro de 200 cellules mémoire de type OxRAM (issu de la publication Gilbert Sassine et al., « Sub-pJ consumption and short latency time in RRAM arrays for high endurance applications », 2018 IEEE International Reliability Physics Symposium (IRPS), DOI: 10.1 109/IRPS.2018.8353675). Comme on peut le voir sur cette figure, la valeur de la résistance haute RH du filament varie fortement d'un cycle à l'autre, la variation relative correspondante étant presque de 100%.

Lors de la lecture de la mémoire, la détection de l'état, soit bassement résistif, soit hautement résistif de la cellule est rendue difficile par ces fluctuations importantes de la résistance haute $R_H$ du filament, d'un cycle de remise à zéro de la mémoire à l'autre. Ces variations de résistance compliquent donc l'opération de lecture de la mémoire et peuvent la rendre moins fiable. Lors de la lecture de la mémoire, la variabilité de la résistance du dispositif peut avoir un impact sur la vitesse de lecture et donc aussi générer des erreurs de lecture. De plus, le fait d'avoir une forte variabilité de l'état hautement résistif, peut engendrer une variabilité dans l'opération de SET (basculement de l'état hautement résistif vers l'état faiblement résistif) et dans la résistance finale après l'opération de SET.

Dans le cas d'une mémoire filamentaire de type OxRam ou CB-Ram, une explication possible des variations de la résistance haute $R_H$ du filament, d'un cycle de remise à zéro à l'autre, est la suivante : Lorsque le filament est rompu pour faire basculer la cellule mémoire dans son état bassement résistif (étape de RESET), seule une portion 42 du filament 41 est détruite (voir figure 1). C'est cette portion 42 qui est ensuite reformée, pour faire basculer la cellule mémoire dans son état bassement résistif (puis détruite à nouveau, et ainsi de suite). Dans l'état hautement résistif de la cellule mémoire, une zone électriquement isolante, dont l'épaisseur d est faible, sépare les parties inférieure et supérieure du filament 41. A travers cette zone isolante, le courant électrique circule par effet tunnel. La résistance haute $R_H$ du filament est donc essentiellement égale à la « résistance tunnel » de cette mince zone isolante, qui varie exponentiellement avec l'épaisseur d de la zone isolante (on notera que la figure 1 est très schématique : la zone de jonction entre les parties supérieure et inférieure du filament a une épaisseur d qui est de l'ordre de la dimension d'un atome ; à cette échelle, les extrémités du filament sont donc en quelque sorte bosselées du fait de la présence de différents atomes). Or, le fait de reformer puis de détruire à nouveau la petite portion 42 de filament s'accompagne en général d'un léger réagencement des atomes les uns par rapport aux autres, au niveau de la jonction entre les parties supérieure et inférieure du filament. Ce réagencement entraine une légère variation de la distance (effective) d, sur laquelle le courant électrique circule par effet tunnel, et donc une variation, cette fois-ci importante, de la résistance tunnel correspondante.

Quoiqu'il en soit, il est souhaitable de s'affranchir des variations de résistance électrique haute de la cellule mémoire, d'un cycle de remise à zéro à l'autre, pour rendre l'opération de lecture de cette cellule plus simple, et pour rendre le stockage d'information en son sein plus fiable.

Dans le domaine des mémoires résistives non-volatiles, on connait le document US 2011/0103131, qui décrit une cellule mémoire avec, entre deux électrodes, une couche active ayant une résistance variable, ainsi qu'une couche ayant une résistance fixe. La couche de résistance fixe a une résistance comprise entre 0.1 et 10 fois la résistance de la couche active dans son état hautement résistif.

On connait aussi le document US 2005/243596, qui décrit une résistance de dérivation connectée électriquement en parallèle d'une couche active.

## RESUME

Dans ce contexte, on propose un dispositif mémoire non-volatile de type filamentaire, comprenant une première électrode, une deuxième électrode et une couche active s'étendant entre la première électrode et la deuxième électrode, la couche active reliant électriquement la première électrode à la deuxième électrode, le dispositif étant destiné à présenter :

- un état bassement résistif, dans lequel un filament conducteur reliant électriquement la première électrode à la deuxième électrode s'étend de part en part à travers la couche active, de manière ininterrompue, ledit filament ayant une résistance électrique basse, et
- un état hautement résistif, dans lequel ledit filament est rompu, ledit filament ayant une résistance électrique haute.

Le dispositif comprend une résistance de dérivation connectée électriquement en parallèle de ladite couche active, entre la première électrode et la deuxième électrode, et, dans ce dispositif :

- une couche d'espacement, électriquement isolante, recouvre en partie la première électrode, une cavité étant ménagée dans cette couche d'espacement, ladite cavité ayant un fond, constitué par une partie de la première électrode qui n'est pas recouverte par la couche d'espacement, la cavité ayant au moins une face latérale qui, dans la couche d'espacement, délimite latéralement la cavité,
- la résistance de dérivation est formée au moins en partie par une couche en matériau résistif appliquée contre la face latérale de la cavité,
- la couche active du dispositif s'étend parallèlement au fond de la cavité et se prolonge en recouvrant ladite couche en matériau résistif, la couche active ayant une épaisseur inférieure au tiers d'une épaisseur de la couche d'espacement, et
- la deuxième électrode recouvre en partie la couche d'espacement et remplit une partie au moins de ladite cavité en recouvrant la couche active.

On comprend que, grâce au dispositif qui vient d'être décrit, une fois l'opération de forming effectuée (i.e. une fois que le dispositif comporte un filament conducteur créé pour la première fois), la configuration de la résistance de dérivation connectée électriquement en parallèle de la couche active, entre la première électrode et la deuxième électrode, entraîne que cette même résistance de dérivation est connectée électriquement, en parallèle avec le filament formé, entre la première électrode et la deuxième électrode. Comme expliqué en détail plus bas, cela permet de limiter les variations de résistance électrique haute de la cellule mémoire, d'un cycle de remise à zéro à l'autre.

La structure particulière du dispositif, où la couche active remonte sur les bords de la cavité en recouvrant la couche résistive, peut paraître peu propice en termes de fonctionnement, au premier abord. En effet dans cette configuration, le filament conducteur pourrait se former dans la partie de la couche active qui remonte sur les bords de la cavité (c'est-à-dire dans la partie de la couche active qui est parallèle à la face latérale de la cavité, et qui recouvre la couche résistive), au lieu de se former dans la partie de la couche active qui est parallèle au fond de la cavité. Et dans ce cas, les valeurs des résistances hautes et basses du dispositif se trouvent modifiées, par rapport au fonctionnement attendu. Mais en fait, la probabilité que le filament se forme dans cette partie de la couche active, qui est parallèle à la face latérale (ou aux faces latérales) de la cavité, est faible, car le « forming » se produit préférentiellement là où le champ électrique est le plus fort.

En termes de fonctionnement, cette structure ne présente donc pas de réel inconvénient, par rapport à une structure dans laquelle la couche active recouvrirait seulement le fond de la cavité par exemple. Et en termes de fabrication, elle s'avère nettement plus commode à fabriquer. En effet, comme la couche active remonte au moins en partie sur les bords de la cavité, on peut réaliser cette couche active par une technique de dépôt conforme, en venant en quelque sorte tapisser le fond et les bords de la cuvette formée par la cavité. Cela simplifie nettement la fabrication par rapport à d'autres types techniques. La structure du dispositif, avec ses différentes couches déposées de manière conforme dans le via formé par la cavité, est d'ailleurs bien adaptée, dans son ensemble, aux techniques de fabrication employées en micro-électronique, et s'avère propice à l'obtention de dispositifs mémoire de petites dimensions (occupant typiquement une surface inférieure à quelques microns carrés, par exemple inférieure à 3 microns carrés).

De plus, comme la première électrode remplit une partie au moins de la cavité, en recouvrant la couche active, elle vient combler la partie de la cavité qui n'est pas occupée par la couche active. L'épaisseur de la couche active peut donc être ajustée librement, indépendamment de l'épaisseur de la couche d'espacement.

Par « dépôt conforme », on entend un dépôt au cours duquel le matériau déposé recouvre les différentes portions de la surface sur laquelle il est déposé, même si ces surfaces sont orientées différemment les unes des autres. En particulier, le matériau déposé de manière conforme recouvre à la fois les portions horizontales et les portions verticales de cette surface (ici, le matériau recouvre à la fois le fond, et la ou les faces latérales de la cavité, par exemple). La couche déposée de manière conforme croît ainsi conformément à la topographie de la surface sur laquelle elle est déposée, en reproduisant la forme de cette surface.

Par « couche active reliant électriquement la première électrode à la deuxième électrode », on entend une couche active qui relie directement la première électrode et la deuxième électrode (i.e. contact direct de la couche active avec les première et deuxième électrode, c'est-à-dire sans intermédiaire) ou une couche active qui relie indirectement la première électrode et la deuxième électrode (i.e. par le biais d'une autre zone électriquement conductrice).

Le dispositif décrit ci-dessus est destiné à présenter non simultanément un état bassement résistif, dans lequel un filament conducteur reliant électriquement la première électrode à la deuxième électrode s'étend de part en part à travers la couche active, de manière ininterrompue, ledit filament ayant une résistance électrique basse, et un état hautement résistif, dans lequel ledit filament est rompu, ledit filament ayant une résistance électrique haute.

La résistance de dérivation, formée par exemple d'un matériau résistif, légèrement conducteur électriquement, n'est pas le siège de la formation ou de la rupture d'un filament conducteur, lors des cycles d'écriture et de remise à zéro de la mémoire. La résistance de dérivation est sensiblement constante. Elle ne varie pas notablement au cours des cycles d'écriture et de remise à zéro successifs.

Ajouter cette résistance de dérivation $R_{//}$, essentiellement constante, permet de limiter les variations de la résistance haute du dispositif $R_{TOT,H}$, malgré les variations la résistance haute du filament $R_H$ d'un cycle de remise à zéro de la mémoire à l'autre.

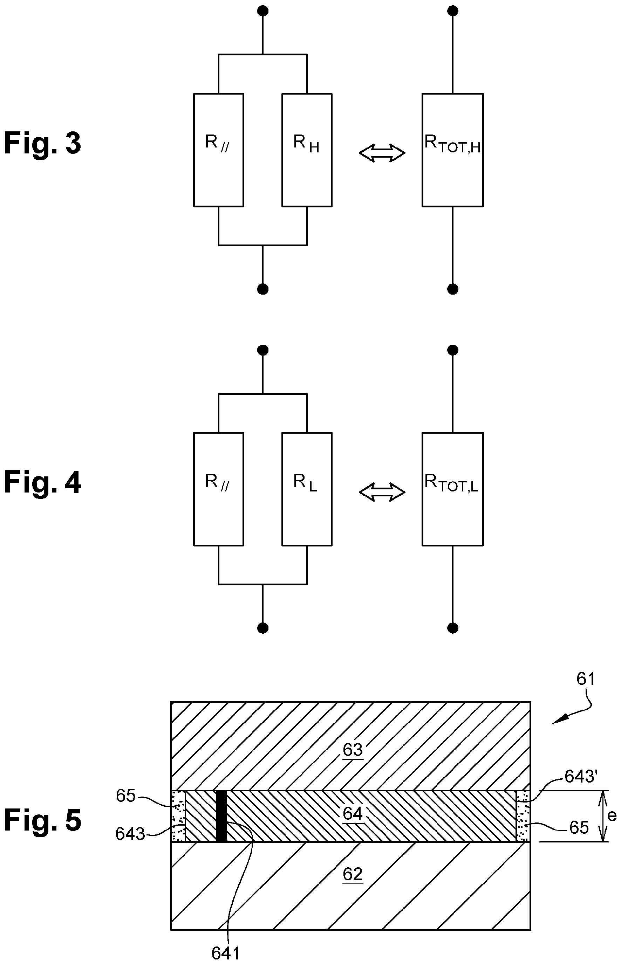

En effet, dans son état hautement résistif, le dispositif peut être représenté par un circuit électrique équivalent comprenant la résistance de dérivation $R_{//}$, et, connectée en parallèle, la résistance haute du filament, $R_H$ (voir figure 3), l'ensemble ayant une résistance $R_{TOT,H}$, donnée par la formule F1 suivante :
[Math. 1]

$$R_{TOT,H} = \frac{1}{1/R_{//} + 1/R_H} \qquad (F1)$$

Et cette formule montre bien que les variations relatives de la résistance haute du dispositif, $R_{TOT,H}$ , sont inférieures aux variations relatives de la résistance haute du filament $R_H$, puisque l'on ajoute à la quantité $1/R_H$ (variable) la quantité $1/R_{//}$, qui est essentiellement constante et qui amoindrit donc les variations relatives de l'ensemble.

Cette formule montre aussi que les variations relatives de la résistance haute du dispositif $R_{TOT,H}$ sont d'autant plus faibles que la résistance de dérivation $R_{//}$ est petite. En effet, plus la résistance de dérivation est petite, et plus le terme $1/R_{//}$, ajouté au terme $1/R_H$ pour en atténuer les variations, est grand. En pratique, on a donc intérêt à choisir une résistance de dérivation faible, typiquement inférieure ou égale à la résistance haute du filament.

La réduction des variations de résistance haute du dispositif $R_{TOT,H}$ (obtenue quelle que soit la valeur de $R_{//}$, mais plus ou moins fortement) se comprend bien dans le cas particulier où la résistance de dérivation $R_{//}$ est nettement plus faible que la résistance haute du filament $R_H$, par exemple trois fois plus faible que celle-ci. En effet, dans ce cas, la résistance haute du dispositif $R_{TOT,H}$ , est quasiment égale à la résistance de dérivation $R_{//}$, et reste donc effectivement constante d'un cycle de remise à zéro de la mémoire à l'autre, même si la résistance haute du filament $R_H$ varie.

On remarquera que l'ajout de la résistance de dérivation, dont l'effet bénéfique vient d'être présenté, va en quelque sorte à l'encontre même du principe de fonctionnement d'une mémoire de type filamentaire, puisqu'une partie du courant électrique traversant le dispositif va alors être déviée vers cette résistance, qui est invariable quelle que soit la donnée (0 ou 1) stockée dans le dispositif. Autrement formulé, à cause de cette résistance de dérivation constante, l'écart $R_{TOT,H}$ - $R_{TOT,L}$ entre la résistance haute du dispositif $R_{TOT,H}$ et sa résistance basse $R_{TOT,L}$ sera plus faible que sans la résistance de dérivation, alors qu'il parait a priori souhaitable de conserver un écart le plus grand possible entre ces deux résistances.

Mais, dans un dispositif de mémoire de type filamentaire (au contraire, par exemple, d'une mémoire non volatile magnétique de type MRAM - selon l'acronyme de « Magnetic Random Access Memory »), la résistance haute $R_H$ est souvent largement plus grande que la résistance basse $R_L$, le plus souvent 10 fois plus grande, voire plus. Il est donc possible de choisir la résistance de dérivation $R_{//}$ de manière à ce qu'elle soit à la fois nettement plus petite que la résistance haute du filament $R_H$ (pour limiter fortement les variations de la résistance haute du dispositif $R_{TOT,H}$, d'un cycle de remise à zéro à l'autre), et nettement plus grande que la résistance basse du filament $R_L$ (pour conserver un écart important entre $R_{TOT,H}$ et $R_{TOT,L}$). On obtiendra alors un dispositif ayant une résistance haute $R_{TOT,H}$ qui variera très peu, d'un cycle de remise à zéro à l'autre, tout en conservant un écart substantiel entre la résistance haute $R_{TOT,H}$ et la résistance basse $R_{TOT,L}$.

La résistance de dérivation $R_{//}$ permettra en outre d'améliorer la stabilité de l'état bassement résistif du dispositif, notamment lorsque le dispositif sera soumis à des températures élevées. Dans un dispositif de type OxRam classique sans résistance de dérivation, lorsque le dispositif, placé dans son état bassement résistif, est soumis à des températures élevées, on observe couramment, au cours du temps, une augmentation progressive de la valeur de la résistance basse du filament $R_L$, et parfois même une rupture du filament faisant basculer le dispositif vers son état hautement résistif. L'ajout de la résistance de dérivation permettra de réduire cette dérive de la valeur de la résistance basse du dispositif. En effet, le courant électrique qui traversera le dispositif sera dévié vers la résistance de dérivation $R_{//}$, réduisant ainsi l'échauffement local causé par le passage du courant électrique dans la petite portion de filament (portion 42, de faible section - voir la figure 1) qui joint la partie supérieure et la partie inférieure du filament. On réduira ainsi les contraintes thermiques au niveau de cette petite portion de filament, ce qui améliorera sa durée de vie, en particulier à haute température, la résistance de dérivation permettant de relâcher le stress thermique sur le dispositif mémoire.

Outre les caractéristiques mentionnées ci-dessus, le dispositif décrit ci-dessus peut présenter une ou plusieurs caractéristiques complémentaires parmi les suivantes, considérées individuellement ou selon toutes les combinaisons techniquement possibles :

- la couche active comprend un filament conducteur qui relie électriquement la première électrode à la deuxième électrode, le dispositif ayant :

  - un état bassement résistif, dans lequel le filament conducteur s'étend de part en part à travers la couche active, de manière ininterrompue, ledit filament ayant une résistance électrique basse, et

  - un état hautement résistif, dans lequel ledit filament est rompu, ledit filament ayant une résistance électrique haute,

  ladite résistance de dérivation étant connectée électriquement en parallèle dudit filament, entre la première électrode et la deuxième électrode.

- la résistance de dérivation est inférieure ou égale à la résistance haute du filament.

- la résistance de dérivation est supérieure ou égale à la résistance basse du filament.

- la résistance de dérivation est inférieure à 100 kiloohms.

- la résistance de dérivation est supérieure à 12,9 kiloohms.

- une couche en matériau diélectrique est intercalée entre la couche active et ladite couche de matériau résistif.

- la couche active, qui s'étend de la première électrode à la deuxième électrode, est délimitée latéralement par au moins une face latérale, et la couche en matériau résistif, qui forme une partie au moins de la résistance de dérivation, s'étend de la première électrode à la deuxième électrode, parallèlement à la face latérale de la couche active.

- la couche en matériau diélectrique est intercalée entre la face latérale de la couche active et ladite couche de matériau résistif.

- ladite couche en matériau résistif s'étend aussi sur le fond de la cavité, entre la couche active et le fond de la cavité.

- le dispositif comprend un bloc électriquement isolant qui divise la cavité en au moins une première sous-cavité et une deuxième sous-cavité, et une troisième électrode, isolée électriquement de la deuxième électrode, et la deuxième électrode remplit la première sous-cavité tandis que la troisième électrode remplit la deuxième sous-cavité.

- ledit matériau résistif a une conductivité électrique comprise entre 0,1 ohm×centimètre et 10 ohms×centimètres.

- la couche active est formée d'un oxyde métallique, notamment dans le cas d'une OxRam ou d'un matériau électrolytique, par exemple dans le cas d'une CbRam.

On propose également un procédé de fabrication d'un dispositif mémoire non-volatile de type filamentaire, comprenant les étapes suivantes :

- dépôt, sur la première électrode, d'une couche d'espacement, électriquement isolante,

- gravure, dans la couche d'espacement, d'une cavité ayant un fond, constitué par une partie de la première électrode qui, après gravure, n'est plus recouverte par la couche d'espacement, la cavité ayant au moins une face latérale qui, dans la couche d'espacement, délimite latéralement la cavité,

- réalisation d'une résistance de dérivation, formée au moins en partie par une couche en matériau résistif déposée contre la face latérale de la cavité,

- dépôt conforme d'une couche active, qui s'étend parallèlement au fond de la cavité et qui se prolonge en recouvrant ladite couche en matériau résistif,

- réalisation d'une deuxième électrode qui recouvre en partie la couche d'espacement et remplit une partie au moins de ladite cavité en recouvrant la couche active,
la couche active reliant électriquement la première électrode à la deuxième électrode, la résistance de dérivation étant connectée électriquement en parallèle de ladite couche active, entre la première électrode et la deuxième électrode, le dispositif étant destiné à présenter :

    - un état bassement résistif, dans lequel un filament conducteur, reliant électriquement la première électrode à la deuxième électrode, s'étend de part en part à travers la couche active, de manière ininterrompue, ledit filament ayant une résistance électrique basse, et

    - un état hautement résistif, dans lequel ledit filament est rompu, ledit filament ayant une résistance électrique haute.

Ce procédé peut comprendre en outre les étapes suivantes, exécutées après la réalisation de la résistance de dérivation, et avant le dépôt de la couche active:

- dépôt conforme d'une couche en matériau diélectrique, ladite couche s'étendant parallèlement au fond de la cavité et se prolongeant parallèlement à la face latérale de la cavité, la couche en matériau diélectrique recouvrant ladite couche en matériau résistif,

- gravure de la couche en matériau diélectrique, de manière à retirer la partie de cette couche qui s'étend parallèlement au fond de la cavité.

Le dispositif de mémoire non-volatile présenté ci-dessus et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif.

[Fig. 1] La figure 1 représente schématiquement une cellule mémoire de type filamentaire, plus précisément de type OxRam, vue en coupe,

[Fig. 2] La figure 2 montre les valeurs médianes des résistances basse RL et des résistances haute RH d'un filament conducteur de 200 cellules mémoire de la figure 1, obtenues au cours de 10 millions cycles successifs d'écriture et de remise à zéro des cellules mémoire,

[Fig. 3] La figure 3 représente un circuit électrique équivalent à un dispositif de mémoire de type filamentaire, le dispositif étant dans un état hautement résistif,

[Fig. 4] La figure 4 représente un circuit électrique équivalent au même dispositif de mémoire de type filamentaire, le dispositif étant dans un état bassement résistif,

[Fig. 5] La figure 5 représente schématiquement un premier mode de réalisation du dispositif de mémoire en question, vu en coupe,

[Fig. 6] La figure 6 représente schématiquement un deuxième mode de réalisation du dispositif de mémoire, vu en coupe,

[Fig. 7] La figure 7 représente schématiquement un troisième mode de réalisation du dispositif de mémoire, vu en coupe,

[Fig. 8] La figure 8 représente schématiquement un quatrième mode de réalisation du dispositif de mémoire, vu en coupe,

[Fig. 9] La figure 9 représente schématiquement un cinquième mode de réalisation du dispositif de mémoire, vu en coupe,

**DESCRIPTION DETAILLEE**

Comme déjà indiqué, la présente technologie concerne un dispositif mémoire non-volatile de type filamentaire, par exemple un dispositif de type OxRam, ou de type CB-RAM, dans lequel les fluctuations de la résistance haute du dispositif $R_{TOT,H}$, d'un cycle de remise à zéro à l'autre, sont rendues particulièrement faibles grâce à une résistance de dérivation $R_{//}$, connectée électriquement en parallèle du filament conducteur présent dans la couche active du dispositif.

Différents modes de réalisation de ce dispositif, qui portent respectivement les références 61 ; 71 ; 81 ; 91 ; 101, sont représentés schématiquement sur les figures 5 à 9. La géométrie et l'agencement de certains éléments du dispositif varient, d'un mode de réalisation à l'autre, mais ces différents modes de réalisation ont de nombreux points communs. D'un mode de réalisation à l'autre, les éléments identiques ou correspondants seront donc repérés par les mêmes signes de référence et ne seront pas nécessairement décrits à chaque fois.

Le dispositif 61 de la figure 5 est présenté à titre d'information, et il ne fait pas partie de l'invention, telle que définie par la revendication 1 déposée initialement.

Dans chacun de ces modes de réalisation, le dispositif 61 ; 71 ; 81 ; 91 ; 101 comprend :

- une première électrode 62 ; 72,

- une deuxième électrode 63 ; 73 ; 103, et

- une couche active 64 ; 74 ; 140, 140' qui s'étend entre la première électrode et la deuxième électrode, le filament conducteur 641 ; 741 ; 141, 141' mentionné plus haut traversant cette couche active pour relier électriquement la première électrode à la deuxième électrode.

La couche active est isolante électriquement, sauf au niveau du filament en question.

Le terme couche désigne ici une étendue de matière délimitée notamment par deux surfaces opposées parallèles entre elles, ou sensiblement parallèles entre elles (c'est-à-dire parallèles à plus ou moins 15 degrés près).

Comme indiqué plus haut, le dispositif 61 ; 71 ; 81 ; 91 ; 101 comprend aussi une résistance de dérivation $R_{//}$, connectée électriquement en parallèle du filament 641 ; 741 ; 141, 141', entre la première électrode et la deuxième électrode. Dans les modes de réalisation représentés sur les figures, cette résistance de dérivation est formée d'une ou plusieurs couches 65 ; 75 ; 95 ; 105, 105' en matériau résistif, légèrement conducteur électriquement. La ou les couches en matériau résistif s'étendent chacune de la première électrode à la deuxième électrode.

La première électrode 62 ; 72 et la deuxième électrode 63 ; 73 ; 103 sont électriquement conductrices. Elles sont par exemple formées d'un ou plusieurs matériaux métalliques, tels que le Titane Ti ou le platine Pt. Les électrodes peuvent comprendre en particulier une ou plusieurs couches métalliques.

Dans le cas où le dispositif est un dispositif de type OxRam, la couche active 64 ; 74 ; 140, 140' est formée plus précisément d'un oxyde de métal, par exemple un oxyde de Tantale ou d'Hafnium. Et dans le cas où le dispositif est un dispositif de type CB-RAM, la couche active est formée d'un électrolyte solide, dans lequel des cations métalliques peuvent être relocalisés et réduits pour former le filament conducteur. La couche active peut avoir une épaisseur e comprise entre 3 et 50 nanomètres.

En plus de la couche ou des couches métalliques mentionnées plus haut, la première électrode 62 ; 72 et/ou la deuxième électrode 63 ; 73 ; 103 peut comprendre, du côté de la couche active, une ou plusieurs couches auxiliaires (non représentées sur les figures) telle qu'une couche réservoir susceptible d'échanger des lacunes en oxygènes avec la couche active, ou telle qu'une couche de protection empêchant la migration d'oxygène.

Le dispositif 61 ; 71 ; 81 ; 91 ; 101 présente :

- un état bassement résistif, dans lequel le filament 641 ; 741 ; 141, 141' conducteur s'étend de part en part à travers la couche active 64 ; 74 ; 140, 140' de manière ininterrompue, le filament ayant une résistance électrique basse $R_L$, et

- un état hautement résistif, dans lequel le filament 641 ; 741 ; 141, 141' est rompu, le filament ayant une résistance électrique haute $R_H$.

Comme nous le détaillerons par la suite, la résistance de dérivation $R_{//}$ est choisie supérieure à la résistance basse du filament $R_L$.

Comme expliqué dans la partie intitulée « résumé » et comme illustré par la figure 3, dans son état hautement résistif, la résistance électrique totale du dispositif, $R_{TOT,H}$, est celle d'un circuit électrique équivalent comprenant la résistance de dérivation $R_{//}$, et, connectée en parallèle, la résistance haute du filament, $R_H$. La résistance haute du dispositif $R_{TOT,H}$ est donc égale à $1/(1/R_{//} + 1/R_H)$.

Grâce à la résistance de dérivation $R_{//}$, les fluctuations relatives de la résistance haute du dispositif $R_{TOT,H}$, d'un cycle de remise à zéro à l'autre pour un même dispositif, sont donc plus faibles que les fluctuations relatives de la résistance haute du filament $R_H$ (plus d'explications à ce sujet sont données dans la partie présentant le « résumé»). Limiter ainsi les variations de la résistance haute du dispositif $R_{TOT,H}$ rend le stockage de données dans le dispositif plus fiable, et rend la lecture d'une donnée stockée plus simple à réaliser.

Les variations de la résistance haute du dispositif $R_{TOT,H}$, d'un cycle de remise à zéro à l'autre, sont réduites d'autant plus fortement que le rapport $R_{//}/R_H$ est petit. C'est pourquoi la résistance de dérivation $R_{//}$ est choisie ici inférieure à la résistance haute du filament $R_H$. Ici, la résistance de dérivation $R_{//}$ est plus précisément inférieure à la moyenne de la résistance haute du filament $R_H$ (résistance dont on rappelle qu'elle fluctue d'un cycle de remise à zéro à l'autre).

Lorsque le dispositif est un dispositif de type OxRam, le dispositif peut par exemple être fabriqué de manière à ce que la résistance de dérivation $R_{//}$ soit inférieure à 100 kiloOhms. Dans ce type de dispositif, la résistance haute du filament $R_H$ a une valeur moyenne qui est généralement supérieure ou égale 100 kiloOhms (cf. figure 2). Fabriquer le dispositif de manière à ce que la résistance de dérivation $R_{//}$ soit inférieure à 100 kOhms permet donc d'assurer, en général, que la résistance de dérivation soit inférieure à la moyenne de la résistance haute du filament $R_H$.

Dans son état bassement résistif, le dispositif 61 ; 71 ; 81 ; 91 ; 101 a une résistance électrique totale, $R_{TOT,L}$ est celle d'un circuit électrique équivalent comprenant la résistance de dérivation $R_{//}$, et, connectée en parallèle, la résistance basse du filament $R_L$ (voir la figure 4). La résistance basse du dispositif, $R_{TOT,L}$, est donc égale à $1/(1/R_{//} + 1/R_L)$.

L'écart $R_{TOT,H}$ - $R_{TOT,L}$ entre la résistance haute du dispositif $R_{TOT,H}$ et sa résistance basse $R_{TOT,L}$ est d'autant plus faible que la résistance de dérivation $R_{//}$ est faible.

Cette diminution de l'écart entre $R_{TOT,H}$ et $R_{TOT,L}$, lorsque la résistance de dérivation $R_{//}$ diminue, se comprend bien dans le cas particulier pour lequel la résistance de dérivation $R_{//}$ est à la fois nettement plus petite que la résistance haute du filament $R_H$, et nettement plus grande que la résistance basse du filament $R_L$. En effet, dans ce cas, la résistance haute du dispositif, $R_{TOT,H}$, est quasiment égale à la résistance de dérivation $R_{//}$, tandis que la résistance basse du dispositif, $R_{TOT,L}$ est quasiment égale à la résistance basse du filament $R_L$. Dans cette situation, on comprend bien que le fait de diminuer la résistance de dérivation $R_{//}$, en la faisant s'approcher de la résistance basse du filament $R_L$, rend la résistance haute du dispositif $R_{TOT,H}$ plus proche de la résistance basse du dispositif $R_{TOT,L}$.

Or un écart important entre $R_{TOT,H}$ et $R_{TOT,L}$ facilite l'opération de la lecture du dispositif, puisque les états hautement résistif et bassement résistif du dispositif correspondent alors à des niveaux de résistance nettement différents l'un de l'autre.

Aussi, pour conserver un écart $R_{TOT,H}$ - $R_{TOT,L}$ important, la résistance de dérivation $R_{//}$ est choisie ici supérieure à la résistance basse du filament $R_L$.

En pratique, lorsque le dispositif est de type OxRAM, la résistance basse du filament $R_L$ est de quelques kiloOhms environ.

La résistance basse du filament $R_L$ obtenue à l'issue de la fabrication du dispositif, après l'étape de « forming », peut varier de manière assez importante d'un dispositif à l'autre, même si les dispositifs sont initialement identiques.

Mais même si la valeur de la résistance basse du filament $R_L$, qui sera obtenue à l'issue de la fabrication, ne peut pas être prévue exactement, on sait qu'elle reste inférieure à 12,9 kiloOhms. Cette valeur est celle du quantum de résistance Ro, égal à $h/(2e^2)$, h étant la constante de Planck et e la charge d'un électron. Cette valeur de résistance correspond, à quelques variations près, à la résistance électrique d'une jonction élémentaire entre deux atomes d'un matériau conducteur, en contact l'un avec l'autre. Lorsque le filament conducteur a été reformé (après une étape de SET), la résistance du filament est donc toujours inférieure à 12,9 kiloOhms (puisque au moins un atome de la partie supérieure du filament vient alors en contact avec un atome de la partie inférieure du filament).

Dans les modes de réalisation présentés ici, le dispositif 61 ; 71 ; 81 ; 91 ; 101 est fabriqué de manière à ce que la résistance de dérivation $R_{//}$ soit supérieure à 12,9 kiloOhms. Comme expliqué ci-dessus, cela assure généralement que la résistance de dérivation $R_{//}$ soit supérieure à la résistance basse du filament $R_L$ (malgré la variabilité de la valeur de $R_L$ d'un dispositif à l'autre, mentionnée plus haut).

Comme déjà indiqué, la résistance de dérivation $R_{//}$ permettra aussi d'améliorer la stabilité de l'état bassement résistif du dispositif.

En effet, une partie du courant électrique qui traversera le dispositif passera alors par la résistance de dérivation $R_{//}$, réduisant ainsi l'intensité du courant qui traversera le filament, et donc son échauffement. A ce sujet, on notera qu'une tension de polarisation est généralement appliquée au dispositif de mémoire (lorsque la mémoire est alimentée électriquement), et que le courant électrique total qui traverse le dispositif a alors une valeur à peu près fixe (typiquement de quelques centaines de microAmpères). Puisque ce courant total a une valeur sensiblement fixe, l'ajout de la résistance de dérivation permettra donc bien de réduire le courant électrique qui transitera par le filament, en déviant une partie substantielle du courant électrique total vers la résistance de dérivation $R_{//}$, réduisant ainsi l'échauffement en question.

La structure géométrique du dispositif 61 ; 71 ; 81 ; 91 ; 101 est maintenant présentée plus en détail, en référence aux figures 5 à 9.

Dans ces modes de réalisation, la couche active 64 ; 74 ; 140, 140' et la deuxième électrode 63 ; 73 ; 103 sont empilées sur la première électrode 62 ; 72, qui est plane. Dans une direction perpendiculaire à la surface principale de la première électrode 62 ; 72, la couche active est délimitée par les première et deuxième électrodes, en étant enserrée entre ces deux électrodes 67, 72, 63, 73. Et latéralement, la couche active 64 ; 74 ; 140, 140' est délimitée par des faces latérales 643, 643' ; 743, 743' ; 143, 143'. Autrement formulé, l'extension de la couche active, dans un plan parallèle à la première électrode, est limitée par ces faces latérales. Dans les modes de réalisation représentés sur les figures, ces faces latérales 643, 643' ; 743, 743' ; 143, 143' s'étendent dans des plans perpendiculaires à la première électrode 62 ; 72.

Dans le mode de réalisation illustré par la figure 5, la deuxième électrode 63 du dispositif 61 est plane, et est disposée parallèlement à la première électrode 62. La couche active 64, qui s'étend entre ces deux électrodes, est plane elle aussi et s'étend dans un plan parallèle à la première électrode 62. Et la résistance de dérivation $R_{//}$ est formée par une même couche en matériau résistif 65 qui forme un revêtement d'un seul tenant s'étendant sur tout le pourtour de la couche active 64, en l'entourant latéralement. La couche active 64 est par exemple de forme cylindrique et est entourée par la couche résistive 65 formant la résistance de dérivation. La section du cylindre peut être circulaire, carré ou rectangulaire par exemple.

En l'occurrence, la couche en matériau résistif 65 est appliquée directement contre les faces latérales 643, 643' de la couche active 64. On comprend ici que dans le cas d'une structure cylindrique de section circulaire telle que décrite plus haut, il n'y a qu'une paroi continue formant la couche en matériau résistif 65 et venant latéralement contre la couche active. Le fait d'évoquer plusieurs faces latérales n'est donc nullement limitatif et vise surtout à faciliter la compréhension des figures en vue en coupe.

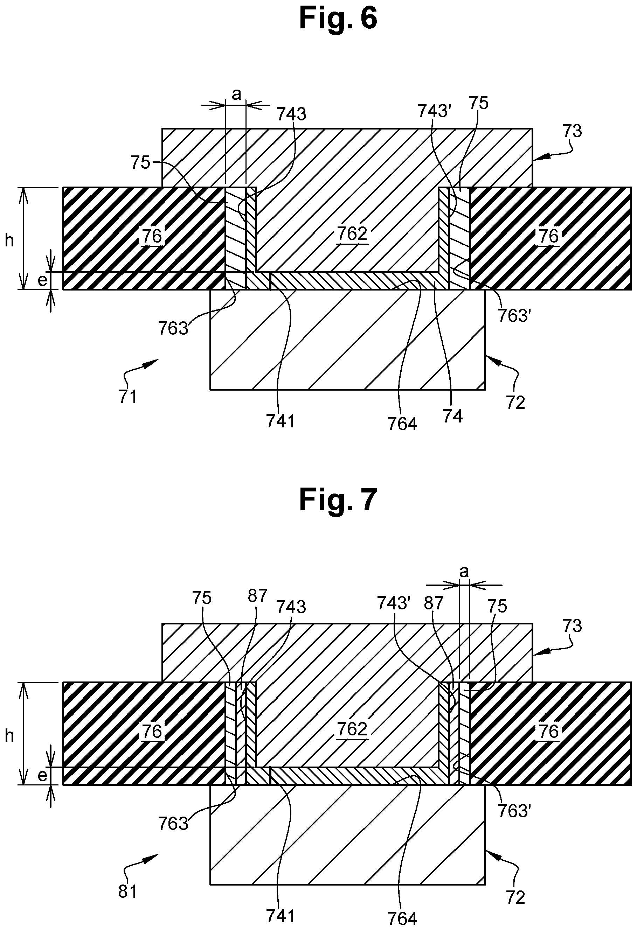

En variante, une couche en matériau diélectrique, isolante électriquement, pourrait toutefois être intercalée entre les faces latérales 643, 643' de la couche active 64 et la couche en matériau résistif 64, comme c'est le cas dans les modes de réalisation des figures 6 à 8 décrits plus loin.

Dans les modes de réalisation illustrés par les figures 6 à 8, la résistance de dérivation $R_{//}$ est aussi réalisée sous la forme d'une couche en matériau résistif 75 ; 95 formant un revêtement d'un seul tenant qui s'étend sur tout le pourtour de la couche active 74 en l'entourant latéralement (ce type de revêtement est parfois appelé « liner » dans le domaine de la microélectronique). Cette configuration est bien adaptée aux techniques de fabrication employées en micro-électronique, de même que celle de la figure 5.

Dans le cas de figure 6, la couche en matériau résistif 75 est appliquée directement contre les faces latérales 743, 743' de la couche active 74, au contact de celles-ci.

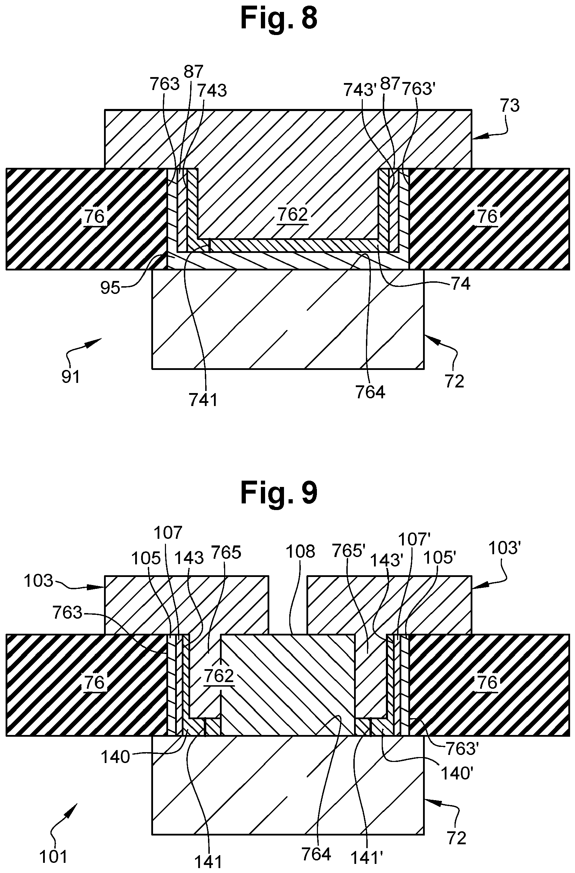

Et dans le cas des figures 7 et 8, la couche en matériau résistif 75 ; 95 est séparée de ces faces latérales 743, 743' par une couche en matériau diélectrique 87, c'est-à-dire en matériau électriquement isolant.

De même que pour le mode de réalisation de la figure 5, dans les modes de réalisation des figures 7 et 8, la couche en matériau résistif qui forme la résistance de dérivation pourrait être formée par une couche en matériau résistif qui s'étende seulement sur certaines des faces latérales de la couche active. La résistance de dérivation pourrait aussi être formée par deux couches en matériau résistifs disjointes l'une de l'autre, et qui s'étendent sur deux faces latérales différentes de la couche active.

Dans le mode de réalisation illustré par la figure 9, le dispositif 101 comprend deux cellules mémoires, et il peut donc stocker deux données binaires, indépendamment l'une de l'autre. Il comprend donc une première couche active 140 et une deuxième couche active 140'. Un filament conducteur 141, 141', tel que décrit ci-dessus, est formé dans chacune de ces couches actives 140, 140'. Le dispositif 101 comprend aussi une première résistance de dérivation et une deuxième résistance de dérivation formées respectivement par une première couche en matériau résistif 105, et par une deuxième couche en matériau résistif 105'. La première couche en matériau résistif 105 s'étend le long d'une face latérale 143 de la première couche active 140, parallèlement à cette face latérale. Et la deuxième couche en matériau résistif 105' s'étend le long d'une face latérale 143' de la deuxième couche active 140', parallèlement à cette face latérale.

Dans les modes de réalisation représentés sur les figures, chaque couche en matériau résistif 65 ; 75 ; 95 ; 105, 105' s'étend perpendiculairement par rapport à la première électrode 62 ; 72.

Dans les modes de réalisation des figures 6 à 9, le dispositif 71 ; 81 ; 91 ; 101 a une structure géométrique particulière, bien adaptée aux techniques de fabrication employées en micro-électronique, et propice à l'obtention de dispositifs mémoire de petites dimensions (occupant typiquement une surface inférieure à quelques microns carrés). Cette structure particulière est présentée ci-dessous.

Dans les modes de réalisation des figures 6 à 9, la deuxième électrode 73 ; 103 ; 103' est séparée de la première électrode 72 par une couche d'espacement 76, isolante électriquement. Une cavité 762, qui forme une sorte de cuvette, est ménagée dans cette couche d'espacement 76. La couche active 74 ; 140, 140' s'étend alors le long des parois de cette cavité, aussi bien au fond que sur les bords de la cavité. En quelque sorte, la couche active 74 ; 140, 140' tapisse, au moins en partie, les parois de la cavités 762. Quant à la deuxième électrode 73 ; 103, elle recouvre en partie la couche d'espacement et remplit au moins en partie la cavité 762 en question pour venir recouvrir la couche active.

Cette configuration permet de réaliser aisément la couche active, 74 ; 140, 140', par dépôt conforme, et avec une liberté importante en ce qui concerne l'épaisseur de cette couche. L'épaisseur de la couche active, 74 ; 140, 140', et même l'épaisseur totale de l'ensemble de couches comprenant la couche active et les éventuelles couches auxiliaires mentionnées plus haut (couche réservoir et couche de protection, par exemple), peut en particulier avoir une épaisseur nettement plus petite que l'épaisseur h de la couche d'espacement, par exemple inférieure à la moitié ou au tiers de l'épaisseur h.

D'ailleurs, la couche active 74 ; 140, 140', la couche en matériau résistif (75 ; 95 ; 105, 105'), et/ou la couche en matériau diélectrique peut avoir une épaisseur faible par rapport à l'extension (au dimensions) de la couche considérée, parallèlement à cette couche (épaisseur de la couche petite par rapport à son étendue superficielle).

La couche d'espacement 76 recouvre en partie la première électrode 72. Le fond 764 de la cavité 762 est constitué par une partie de la première électrode 72 qui n'est pas recouverte par la couche d'espacement 76. La cavité a aussi des faces latérales 763, 763', qui délimitent latéralement la cavité. Ici, ces faces latérales sont perpendiculaires à la première électrode 72.

Dans le cas des figures 6 à 8, la couche en matériau résistif 75 ; 95, qui forment la résistance de dérivation $R_{//}$, est appliquée sur l'ensemble des faces latérales 763, 763' de la cavité (et forme ainsi un revêtement d'un seul tenant qui recouvre la surface latérale de la cavité sur toute sa périphérie). Comme expliqué précédemment, la pluralité de faces latérales 763, 763' est donnée ici à titre d'exemple pour illustrer les vues en coupe, étant entendu que la couche en matériau résistif 75, 95 a généralement une seule face dans le cas d'un cylindre à section sensiblement circulaire (ou 4 faces dans le cas d'un cylindre à section carrée ou rectangulaire) qui entoure la couche active.

Dans les modes de réalisation des figures 6 et 7, la couche en matériau résistif 75 recouvre les faces latérales 763, 763' de la cavité, mais pas son fond 764.

Et dans le mode de réalisation illustré par la figure 8, la couche en matériau résistif 95, appliquée sur les faces latérales 763, 763' de la cavité, se prolonge au fond de la cavité 762 en recouvrant la première électrode 72. La couche en matériau résistif 95 forme alors un revêtement d'un seul tenant qui tapisse l'ensemble des parois de la cavité 762, c'est-à-dire à la fois le fond 764 de la cavité et ses parois latérales 763, 763'. Au niveau du fond 764 de la cavité, le matériau résistif est directement en contact avec la première électrode 72, et est recouvert par la couche active 74.

Pour ce qui est maintenant de la couche active 74, dans les modes de réalisation des figures 6 à 8, elle s'étend parallèlement au fond 764 de la cavité, sur toute la surface du fond, puis se prolonge, perpendiculairement au fond de la cavité, en recouvrant la couche de matériau résistif 75 ; 95 (qui est appliquée contre les parois latérales 763, 763' de la cavité).

Dans les modes de réalisation des figures 6 à 8, la deuxième électrode 73 recouvre en partie la couche d'espacement 76, et remplit la partie de la cavité 762 laissée libre par les couches 74, 75 ; 95, et éventuellement 87 mentionnées ci-dessus. En particulier, le métal ou les métaux, qui forment une partie au moins de la deuxième électrode 76, viennent combler (c'est-à-dire remplir) une partie au moins de cette cavité.

Dans le mode de réalisation illustré par la figure 6, la couche active 74 est appliquée directement contre le fond 764 de la cavité, au contact de la première électrode 72. Et la partie de la couche active 74 qui s'étend perpendiculairement au fond de la cavité, et qui recouvre la couche en matériau résistif 75, est appliquée directement contre la couche en matériau résistif 75, à son contact.

Dans le dispositif 71 illustré par la figure 6, lors de l'étape de « forming », le filament 741 se forme entre la première électrode 72 et la deuxième électrode 73, généralement dans la partie de la couche active 74 qui s'étend parallèlement au fond de la cavité (partie de la couche active 74 appliquée contre la première électrode 72).

Mais, dans ce dispositif 71, le filament peut parfois se former (avec une probabilité moindre) entre la deuxième électrode 73 et la couche en matériau résistif 75, dans la partie de la couche active 74 qui s'étend transversalement, perpendiculairement à la première électrode 72. La valeur de la résistance de dérivation, qui se trouve finalement connectée en parallèle du filament, s'en trouve modifiée, et, en outre, cela ajoute une résistance en série avec le filament, dont la valeur peut être assez importante. Lorsque le filament se forme de cette manière, les valeurs des résistances hautes et basses du dispositif peuvent donc se trouver modifiées par rapport à ce qui serait attendu vu les dimensions h et a de la couche en matériau résistif 75. Le fonctionnement du dispositif peut alors n'être plus optimal.

La probabilité que le filament se forme dans la partie de la couche active 74 qui s'étend verticalement, c'est-à-dire perpendiculairement à la première électrode 72, est néanmoins faible. Toutefois, il est intéressant d'éviter à coup sûr que le filament ne se forme dans cette partie de la couche active 74.

C'est pour cela qu'il est prévu, dans les modes de réalisation illustrés par les figures 7 et 8 (ainsi que dans celui illustré par la figure 9), d'intercaler la couche en matériau diélectrique 87 entre la couche en matériau résistif 75 ; 95 d'une part, et la partie de la couche active 74 qui s'étend verticalement d'autre part. Cela permet d'assurer que le filament 741 se forme dans la partie de la couche active 74 qui s'étend parallèlement au fond de la cavité 762. De plus, la couche en matériau diélectrique 87 permet de protéger la couche en matériau résistif 75 ; 95, en évitant de la mettre directement en contact avec la couche active 74 (couche active qui peut par exemple contenir de l'oxygène). La couche en matériau diélectrique 87 peut par exemple être réalisé en nitrure de silicium $Si_3N_4$, qui constitue une barrière chimique (et électrique) efficace.

Le dispositif 81 du mode de réalisation de la figure 7 est identique au dispositif 71 de la figure 6, si ce n'est qu'il comprend la couche en matériau diélectrique 87 mentionnée ci-dessus.

Le dispositif 91 du mode de réalisation de la figure 8 est identique au dispositif 81 de la figure 7, si ce n'est que la couche en matériau résistif 95 s'étend non seulement sur la parois latérales 763, 763' de la cavité, mais aussi sur le fond 764 de la cavité, comme déjà indiqué. Au niveau du fond de la cavité, la couche en matériau résistif 95 s'interpose donc entre la couche active 74 et la première électrode 72. D'un point de vue électrique, cela a pour effet d'ajouter une résistance électrique supplémentaire, en série avec la résistance du filament 71. Cette résistance supplémentaire est faible (de l'ordre du kiloohms), aussi bien par rapport à la résistance basse du filament $R_L$, que par rapport à la résistance de dérivation $R_{//}$, et ne modifie donc pas le fonctionnement du dispositif. Mais elle permet de rendre l'étape de « forming », qui s'apparente à une sorte de claquage volontaire de la couche active, moins brutale d'un point de vue électrique. Ainsi, le stress électrique vu par la zone active sera amoindri grâce à cette résistance supplémentaire. Avant le forming, le champ électrique se trouve majoritairement aux bornes de la zone active mais après la création du filament, on se retrouve avec un champ important aux bornes d'un filament fragile. Dès lors, le fait d'ajouter cette résistance supplémentaire en série permet de répartir le champ électrique sur le filament et la résistance supplémentaire en série. On notera au passage que la couche active 741 relie électriquement la première électrode 72 à la deuxième électrode 73 indirectement par le biais de cette petite résistance supplémentaire située entre la couche active 74 et la première électrode 72. On notera aussi que cette structure, avec la couche en matériau résistif 95 qui s'étend non seulement sur la ou les parois latérales, mais aussi sur le fond de la cavité, facilite encore plus la fabrication du dispositif, puisqu'il n'est pas nécessaire dans ce cas de graver la couche en matériau résistif, après son dépôt conforme (en effet, dans ce cas, il n'est pas nécessaire de retirer la partie de cette couche qui s'étend parallèlement au fond).

Quant au dispositif 101 de la figure 9, il est similaire à celui de la figure 7, mais la cavité 762 est divisée en une première sous-cavité 765, et une deuxième sous-cavité 765' par un bloc électriquement isolant 108, par exemple un oxyde de remplissage. Cela permet de réaliser deux cellules mémoire dans la même cavité. Ici, le bloc électriquement isolant 108 est appliqué contre la première électrode 72, et s'étend jusqu'au sommet de la cavité 762.

Dans la première sous-cavité 765, la face latérale 763 de la cavité est recouverte par la première couche en matériau résistif 105 mentionnée plus haut (qui forme la première résistance de dérivation du dispositif). Ici, cette couche s'étend seulement sur cette face latérale 763. Une première couche en matériau diélectrique 107 recouvre la première couche en matériau résistif 105. La première couche active 140 s'étend horizontalement, sur le fond de la première sous-cavité 765, et, verticalement, contre la première couche en matériau diélectrique 107. La deuxième électrode 103 recouvre en partie la couche d'espacement 76, et remplit la partie de la première sous-cavité 765 laissée libre par les couches 105, 107 et 140 mentionnées ci-dessus, en venant recouvrir la première couche active 140. En particulier, le métal ou les métaux, qui forment une partie au moins de la deuxième électrode, viennent combler une partie au moins de la première sous-cavité. L'ensemble des éléments situés entre la première électrode 72 et la deuxième électrode 103 constituent la première cellule mémoire du dispositif.

La structure du dispositif au niveau de la deuxième sous cavité 765', est similaire à ce qui vient d'être présenté pour la première sous-cavité 765.

Plus précisément, dans la deuxième sous-cavité 765', la face latérale 763' de la cavité est recouverte par la deuxième couche en matériau résistif 105' (qui forme la deuxième résistance de dérivation du dispositif). Ici, cette couche s'étend seulement sur cette face latérale 763'. Une deuxième couche en matériau diélectrique 107' recouvre la deuxième couche en matériau résistif 105'. La deuxième couche active 140' s'étend horizontalement, sur le fond de la deuxième sous-cavité 765', et, verticalement, contre la deuxième couche en matériau diélectrique 107'. Une troisième électrode 103', isolée électriquement de la deuxième électrode 103 (pour pouvoir adresser indépendamment les deux cellules mémoires) recouvre en partie la couche d'espacement 76 et remplit la partie de la deuxième sous-cavité 765' laissée libre par les couches 105', 107' et 140' mentionnées ci-dessus, en venant recouvrir la deuxième couche active 140'. L'ensemble des éléments situés entre la deuxième électrode 72 et la troisième électrode 103' constituent la deuxième cellule mémoire du dispositif 101.

En variante, le dispositif de la figure 10 pourrait comprendre plus de deux cellules mémoire distinctes.

Dans les différents modes de réalisation représentés sur les figures 6 à 9, la couche d'espacement 76 a une épaisseur h. La couche en matériau résistif 75 ; 95 ; 105, 105' qui forme la résistance de dérivation a donc une longueur, dans la direction suivie par le courant électrique, égale à la hauteur h. La couche en matériau résistif 75 ; 95 ; 105 a par ailleurs une épaisseur a, et une section a×b (section d'entrée dans la couche, au niveau de la deuxième électrode 73 ; 103).

La valeur de la résistance de dérivation $R_{//}$ est donc donnée, en bonne approximation, par la formule F2 suivante :

[Math. 2]

$$R_{//} = \frac{\rho\, h}{a \times b} \qquad (F2)$$

où $\rho$ est la résistivité du matériau résistif en question

En pratique, la hauteur h de la couche d'espacement 76 peut par exemple être comprise entre 30 et 100 nanomètres, l'épaisseur a de la couche active peut être comprise entre 3 et 30 nanomètres, et la « largeur » b de la couche (extension transverse de la couche) est typiquement 10 fois plus grande que son épaisseur a. La quantité h/(a×b) est alors de l'ordre de $10^8$ mètres. Pour obtenir l'ordre de grandeur souhaité pour la résistance de dérivation $R_{//}$, typiquement comprise entre 10 et 100 kiloOhms, un matériau résistif ayant une résistivité $\rho$ de l'ordre de 1 Ohm×centimètre est donc bien adapté.

Plus généralement, un matériau résistif ayant une résistivité ρ comprise entre 0,1 Ohm×centimètre et 10 Ohm×centimètres permet d'obtenir une valeur bien adaptée pour la résistance de dérivation $R_{//}$, pour des dispositifs de mémoire de petite taille tels que décrits ci-dessus, réalisés par des techniques de dépôt de couches de minces.

Le matériau résistif peut être un matériau semi-conducteur, ce qui permet une fabrication commode du dispositif.

Mais la résistivité d'un matériau semi-conducteur varie assez fortement avec la température. Aussi, si le dispositif est destiné à être utilisé dans un environnement soumis à de fortes variations de température, par exemple dans un compartiment moteur de véhicule automobile, la couche en matériau résistif sera plutôt réalisée, par exemple, en carbure de métal (la proportion de carbone étant ajustée de manière à obtenir la valeur de résistivité souhaitée), ce qui permet d'obtenir une valeur de résistivité, et donc une résistance de dérivation $R_{//}$, stable sur une plage de températures étendue.

Les modes de réalisation du dispositif 71 ; 81 ; 91 ; 101, représentés respectivement sur les figures 6 à 9, peuvent être réalisés chacun au moyen d'un procédé de fabrication comprenant notamment les étapes suivantes, réalisées dans cet ordre :

- S1 : réalisation de la première électrode 72,

- S2 : dépôt de la couche d'espacement 76 sur la première électrode 72,

- S3 : réalisation de la cavité 762, en gravant la couche d'espacement,

- S4 : dépôt conforme du matériau résistif destiné à former la résistance de dérivation R//, contre le fond 764 et la face latérale 763 (ou les faces latérales) de la cavité 762,

- S6 : dépôt conforme de la couche active 74 ; 140, 140', la couche active s'étendant alors parallèlement au fond 764, et se prolongeant parallèlement à la face latérale de la cavité (ou parallèlement aux faces latérales de la cavité) en recouvrant la couche en matériau résistif,

- S7 : réalisation de la deuxième électrode 73 ; 103, 103', cette étape comprenant ici les sous-étapes suivantes :

  - S71 : réalisation d'une partie de la deuxième électrode 73 ; 103, cette partie remplissant l'ensemble du volume laissé libre dans la cavité 762, ou dans la première sous-cavité 105, et recouvrant la couche active 74 ; 140, cette partie de la deuxième électrode étant réalisée par dépôt d'un ou plusieurs matériaux électriquement conducteurs,

  - S72 : planarisation de la surface supérieure libre du dispositif, par exemple par polissage mécano-chimique (CMP),

  - S73 : dépôt d'une autre partie de la deuxième électrode 73 ; 103, qui recouvre la cavité 762 ou la première sous-cavité 105, et qui recouvre aussi une partie de la couche d'espacement 76.

De manière optionnelle, l'étape S4 peut comprendre une sous-étape de gravure anisotrope permettant de retirer la partie horizontale de la couche en matériau résistif (c'est-à-dire la partie de cette couche qui s'étend parallèlement au fond 764 de la cavité). Cette gravure est réalisée avant de déposer la couche active. Cette sous-étape est réalisée lorsque l'on souhaite fabriquer un dispositif mémoire tel que celui 71 ou 81 de la figure 6 ou de la figure 7, dans lequel la couche en matériau résistif ne s'interpose pas entre la couche active 74 et la première électrode 72.

Le procédé peut comprendre aussi une étape S5 de réalisation de la couche en matériau diélectrique 87 ; 107, 107' décrite plus haut, cette étape étant exécutée après l'étape S4, et avant l'étape S6. L'étape S5 comprend les sous-étapes suivantes :

- dépôt conforme de la couche en matériau diélectrique 87 ; 107, 107', de sorte que cette couche s'étende parallèlement au fond 764 de la cavité (contre le fond, ou contre la partie horizontale de la couche résistive) et se prolonge parallèlement à la face latérale 763 (ou aux faces latérales), en recouvrant la couche en matériau résistif 75 ; 95 ; 105, 105' et

- gravure de la couche en matériau diélectrique, 87 ; 107, 107', par gravure anisotrope, de manière à retirer la partie de cette couche qui s'étend parallèlement au fond de la cavité 762.

L'étape optionnelle S5 est exécutée lorsque l'on souhaite obtenir un dispositif mémoire tel que celui 81 ; 91 ; 101 des figures 7 à 9, par exemple.

Dans les modes de réalisation des figures 6 à 8, la couche active 74 est d'un seul tenant et recouvre le fond ainsi que la face latérale, ou l'ensemble des faces latérales de la cavité 762. Elle peut donc être réalisée par dépôt conforme, sans gravure ultérieure de la couche active. Ainsi, lors de la fabrication du dispositif 71 ; 81 ; 91 en question, le procédé de fabrication ne comporte pas d'étape intermédiaire de gravure de la couche active, entre l'étape S6 et l'étape S7.

Le procédé qui vient d'être décrit peut comporter d'autres étapes, par exemple une étape de « forming », en plus de celles décrites ci-dessus.

**Revendications**

1. Dispositif (71 ; 81 ; 91 ; 101) mémoire non-volatile de type filamentaire, comprenant une première électrode (72), une deuxième électrode (73 ; 103, 103') et une couche active (74 ; 140, 140') s'étendant entre la première électrode et la deuxième électrode, la couche active (74 ; 140, 140') reliant électriquement la première électrode (72) à la deuxième électrode (73 ; 103, 103'), le dispositif étant destiné à présenter :

   - un état bassement résistif, dans lequel un filament (741 ; 141, 141') conducteur reliant électriquement la première électrode (72) à la deuxième électrode (73 ; 103, 103') s'étend de part en part à travers la couche active, de manière ininterrompue, ledit filament ayant une résistance électrique basse (RL), et
   - un état hautement résistif, dans lequel ledit filament est rompu, ledit filament ayant une résistance électrique haute (RH),

   le dispositif comprenant une résistance de dérivation (R//) connectée électriquement en parallèle de ladite couche active (74 ; 140, 140'), entre la première électrode et la deuxième électrode, dans lequel :

   - une couche d'espacement (76), électriquement isolante, recouvre en partie la première électrode (72), une cavité (762) étant ménagée dans cette couche d'espacement, ladite cavité ayant un fond (764), constitué par une partie de la première électrode (72) qui n'est pas recouverte par la couche d'espacement, la cavité ayant au moins une face latérale (763, 763') qui, dans la couche d'espacement (76), délimite latéralement la cavité,
   - la résistance de dérivation (R//) est formée au moins en partie par une couche en matériau résistif (75 ; 95 ; 105, 105') appliquée contre la face latérale de la cavité (763, 763'),
   - la couche active (74 ; 140, 140') du dispositif s'étend parallèlement au fond (764) de la cavité et se prolonge en recouvrant ladite couche en matériau résistif (75 ; 95 ; 105, 105'), la couche active ayant une épaisseur (e) inférieure au tiers d'une épaisseur (h) de la couche d'espacement (76), et dans lequel
   - la deuxième électrode (73 ; 103, 103') recouvre en partie la couche d'espacement (76) et remplit une partie au moins de ladite cavité (762) en recouvrant la couche active (74 ; 140, 140').

2. Dispositif (71 ; 81 ; 91 ; 101) selon la revendication 1 dans lequel la couche active comprend un filament conducteur (741 ; 141, 141'), qui relie électriquement la première électrode (72) à la deuxième électrode (73 ; 103, 103'), le dispositif ayant :

   - un état bassement résistif, dans lequel le filament (741 ; 141, 141') conducteur s'étend de part en part à travers la couche active, de manière ininterrompue, ledit filament ayant une résistance électrique basse (RL), et
   - un état hautement résistif, dans lequel ledit filament est rompu, ledit filament ayant une résistance électrique haute (RH),

   ladite résistance de dérivation (R//) étant connectée électriquement en parallèle dudit filament (741 ; 141, 141'), entre la première électrode et la deuxième électrode.

3. Dispositif (71 ; 81 ; 91 ; 101) selon la revendication précédente, dans lequel la résistance de dérivation (R//) est inférieure ou égale à la résistance haute du filament (R$_H$).

4. Dispositif (71 ; 81 ; 91 ; 101) selon l'une quelconque des revendications 2 ou 3 dans lequel la résistance de dérivation (R//) est supérieure ou égale à la résistance basse du filament (R$_L$).

5. Dispositif (71 ; 81 ; 91 ; 101) selon l'une quelconque des revendications précédentes, dans lequel la résistance de dérivation (R//) est inférieure à 100 kiloohms.

6. Dispositif (71 ; 81 ; 91 ; 101) selon l'une quelconque des revendications précédentes, dans lequel la résistance de dérivation (R//) est supérieure à 12,9 kiloohms.

7. Dispositif (81 ; 91 ; 101) selon l'une des revendications précédentes, dans lequel une couche en matériau diélectrique (87 ; 107, 107') est intercalée entre la couche active et ladite couche de matériau résistif (75 ; 95 ; 105, 105').

8. Dispositif (71 ; 81 ; 91 ; 101) selon la revendication précédente, dans lequel la couche active (74 ; 140, 140'), qui s'étend de la première électrode (72) à la deuxième électrode (73 ; 103, 103'), est délimitée latéralement par au moins une face latérale (743, 743' ; 143, 143'), et dans lequel la couche en matériau résistif (75 ; 95 ; 105, 105'), qui forme une partie au moins de la résistance de dérivation (R//), s'étend de la première électrode à la deuxième électrode, parallèlement à la face latérale (743, 743' ; 143, 143') de la couche active.

9. Dispositif (81 ; 91 ; 101) selon la revendication précédente, dans lequel la couche en matériau diélectrique (87 ; 107, 107') est intercalée entre la face latérale (743, 743' ; 143, 143') de la couche active et ladite couche de matériau résistif (75 ; 95 ; 105, 105').

10. Dispositif (91) selon l'une des revendications précédentes, dans lequel ladite couche en matériau résistif (95) s'étend en outre sur le fond (764) de la cavité, entre la couche active (74) et le fond (764) de la cavité.

11. Dispositif (101) selon l'une des revendications précédentes, comprenant en outre :

- un bloc électriquement isolant (108) qui divise la cavité (762) en au moins une première sous-cavité (765) et une deuxième sous-cavité (765'), et
- une troisième électrode (103'), isolée électriquement de la deuxième électrode (103),

et dans lequel la deuxième électrode (103) remplit la première sous-cavité (105) tandis que la troisième électrode (103') remplit la deuxième sous-cavité (105').

12. Dispositif (71 ; 81 ; 91 ; 101) selon l'une des revendications précédentes, dans lequel ledit matériau résistif a une conductivité électrique comprise entre 0,1 ohm×centimètre et 10 ohms×centimètres.

13. Dispositif (71 ; 81 ; 91 ; 101) selon l'une des revendications précédentes, dans lequel la couche active (74 ; 140, 140') est formée d'un oxyde métallique.

14. Procédé de fabrication d'un dispositif (71 ; 81 ; 91 ; 101) mémoire non-volatile de type filamentaire, comprenant les étapes suivantes :

- dépôt, sur une première électrode, d'une couche d'espacement (76), électriquement isolante,
- gravure, dans la couche d'espacement (76), d'une cavité (762) ayant un fond (764), constitué par une partie de la première électrode (72) qui, après gravure, n'est plus recouverte par la couche d'espacement (76), la cavité ayant au moins une face latérale (763, 763') qui, dans la couche d'espacement (76), délimite latéralement la cavité (762),
- réalisation d'une résistance de dérivation (R$_{//}$), formée au moins en partie par une couche en matériau résistif (75 ; 95 ; 105, 105') déposée contre la face latérale (763, 763') de la cavité,
- dépôt conforme d'une couche active (74 ; 140, 140'), qui s'étend parallèlement au fond (764) de la cavité et qui se prolonge en recouvrant ladite couche en matériau résistif (75 ; 95 ; 105, 105'), la couche active ayant une épaisseur (e) inférieure au tiers d'une épaisseur (h) de la couche d'espacement (76),
- réalisation d'une deuxième électrode (73 ; 103, 103') qui recouvre en partie la couche d'espacement (76) et remplit une partie au moins de ladite cavité (762) en recouvrant la couche active (74 ; 140, 140'),

la couche active (74 ; 140, 140') reliant électriquement la première électrode (72) à la deuxième électrode (73 ; 103, 103'), la résistance de dérivation (R//) étant connectée électriquement en parallèle de ladite couche active (74 ; 140, 140'), entre la première électrode et la deuxième électrode, le dispositif étant destiné à présenter :

- un état bassement résistif, dans lequel un filament (741 ; 141, 141') conducteur, reliant électriquement la première électrode (72) à la deuxième électrode (73 ; 103, 103'), s'étend de part en part à travers la couche active, de manière ininterrompue, ledit filament ayant une résistance électrique basse (RL), et
- un état hautement résistif, dans lequel ledit filament est rompu, ledit filament ayant une résistance électrique haute (RH).

15. Procédé selon la revendication précédente, comprenant en outre les étapes suivantes, exécutées après la réalisation de la résistance de dérivation (R//), et avant le dépôt de la couche active (74 ; 140, 140') :

- dépôt conforme d'une couche en matériau diélectrique (87 ; 107, 107'), ladite couche s'étendant parallèlement au fond (764) de la cavité et se prolongeant parallèlement à la face latérale (763, 763') de la cavité, la couche en matériau diélectrique recouvrant ladite couche en matériau résistif (75 ; 95 ; 105, 105'),
- gravure de la couche en matériau diélectrique, (87 ; 107, 107'), de manière à retirer la partie de cette couche qui s'étend parallèlement au fond de la cavité (762).

**Patentansprüche**

1. Nichtflüchtige Filamentspeichervorrichtung (71; 81; 91; 101) mit einer ersten Elektrode (72), einer zweiten Elektrode (73; 103, 103') und einer aktiven Schicht (74; 140, 140'), die sich zwischen der ersten Elektrode und der zweiten Elektrode erstreckt, wobei die aktive Schicht (74; 140, 140') die erste Elektrode (72) mit der zweiten Elektrode (73; 103, 103') elektrisch verbindet und die Vorrichtung dazu bestimmt ist, Folgendes aufzuweisen:

- einen niederohmigen Zustand, in dem ein leitendes Filament (741; 141, 141'), der die erste Elektrode (72) mit der zweiten Elektrode (73; 103, 103') elektrisch verbindet, sich ununterbrochen durch die aktive Schicht erstreckt, wobei das Filament einen niedrigen elektrischen Widerstand (RL) hat, und

- einen hochohmigen Zustand, in dem das Filament gerissen ist, wobei das Filament einen hohen elektrischen Widerstand (RH) hat,

wobei die Vorrichtung einen Nebenschlusswiderstand ($R_{//}$) umfasst, der elektrisch parallel zur aktiven Schicht (74; 140, 140') zwischen der ersten Elektrode und der zweiten Elektrode geschaltet ist, wobei:

- eine elektrisch isolierende Abstandsschicht (76) die erste Elektrode (72) teilweise bedeckt, wobei in dieser Abstandsschicht ein Hohlraum (762) ausgespart ist, der einen Boden (764) hat, der von einem Teil der ersten Elektrode (72) gebildet wird, der nicht von der Abstandsschicht bedeckt ist, wobei der Hohlraum mindestens eine Seitenfläche (763, 763') hat, die in der Abstandsschicht (76) den Hohlraum seitlich begrenzt,
- der Nebenschlusswiderstand ($R_{//}$) zumindest teilweise durch eine Schicht aus Widerstandsmaterial (75; 95; 105, 105') gebildet wird, die gegen die Seitenfläche des Hohlraums (763, 763') angelegt wird,
- die aktive Schicht (74; 140, 140') der Vorrichtung sich parallel zum Boden (764) des Hohlraums erstreckt und sich über die Schicht aus Widerstandsmaterial (75; 95; 105, 105') überlappend erstreckt, wobei die aktive Schicht eine Dicke (e) von weniger als einem Drittel einer Dicke (h) der Abstandsschicht (76) aufweist, und wobei
- die zweite Elektrode (73; 103, 103') die Abstandsschicht (76) teilweise bedeckt und zumindest einen Teil des Hohlraums (762) füllt, indem sie die aktive Schicht (74; 140, 140') bedeckt.

2. Vorrichtung (71; 81; 91; 101) nach Anspruch 1, bei der die aktive Schicht ein leitendes Filament (741; 141, 141') umfasst, das die erste Elektrode (72) mit der zweiten Elektrode (73; 103, 103') elektrisch verbindet, wobei die Vorrichtung aufweist:

- einen niederohmigen Zustand, in dem sich das leitende Filament (741; 141, 141') ununterbrochen durch die aktive Schicht erstreckt, wobei das Filament einen niedrigen elektrischen Widerstand (RL) hat, und
- einen hochohmigen Zustand, in dem das Filament gerissen ist, wobei das Filament einen hohen elektrischen Widerstand (RH) hat,

wobei der Nebenschlusswiderstand ($R_{//}$) elektrisch parallel zum Filament (741; 141, 141') zwischen der ersten Elektrode und der zweiten Elektrode geschaltet ist.

3. Vorrichtung (71; 81; 91; 101) nach dem vorhergehenden Anspruch, bei der der Nebenschlusswiderstand ($R_{//}$) kleiner oder gleich dem hohen Widerstand des Filaments (RH) ist.

4. Vorrichtung (71; 81; 91; 101) nach einem der Ansprüche 2 oder 3, bei der der Nebenschlusswiderstand ($R_{//}$) größer oder gleich dem niedrigen Widerstand des Filaments (RL) ist.

5. Vorrichtung (71; 81; 91; 101) nach einem der vorhergehenden Ansprüche, bei der der Nebenschlusswiderstand ($R_{//}$) weniger als 100 Kiloohm beträgt.

6. Vorrichtung (71; 81; 91; 101) nach einem der vorhergehenden Ansprüche, bei der der Nebenschlusswiderstand ($R_{//}$) größer als 12,9 Kiloohm ist.

7. Vorrichtung (81; 91; 101) nach einem der vorhergehenden Ansprüche, bei der eine Schicht aus dielektrischem Material (87; 107, 107') zwischen der aktiven Schicht und der Schicht aus Widerstandsmaterial (75; 95; 105, 105') eingefügt ist.

8. Vorrichtung (71; 81; 91; 101) nach vorhergehendem Anspruch, bei der die aktive Schicht (74; 140, 140'), die sich von der ersten Elektrode (72) zur zweiten Elektrode (73; 103, 103') erstreckt, seitlich durch mindestens eine Seitenfläche (743, 743', 143, 143') begrenzt ist, und bei der die Schicht aus Widerstandsmaterial (75; 95; 105, 105'), die zumindest einen Teil des Nebenschlusswiderstands ($R_{//}$) bildet, sich von der ersten Elektrode zur zweiten Elektrode parallel zur Seitenfläche (743, 743'; 143, 143') der aktiven Schicht erstreckt.

9. Vorrichtung (81; 91; 101) nach vorhergehendem Anspruch, bei der die Schicht aus dielektrischem Material (87; 107, 107') zwischen der Seitenfläche (743, 743'; 143, 143') der aktiven Schicht und der Schicht aus Widerstandsmaterial (75; 95; 105, 105') eingefügt ist.

10. Vorrichtung (91) nach einem der vorhergehenden Ansprüche, bei der sich die Schicht aus Widerstandsmaterial (95) zusätzlich über den Boden (764) des Hohlraums zwischen der aktiven Schicht (74) und dem Boden (764) des Hohlraums erstreckt.

11. Vorrichtung (101) nach einem der vorhergehenden Ansprüche, die außerdem Folgendes umfasst:

- einen elektrisch isolierenden Block (108), der den Hohlraum (762) in mindestens einen ersten Unterhohlraum (765) und einen zweiten Unterhohlraum (765') unterteilt, und
- eine dritte Elektrode (103'), die von der zweiten Elektrode (103) elektrisch isoliert ist,

und in der die zweite Elektrode (103) den ersten Unterhohlraum (105) füllt, während die dritte Elektrode (103') den zweiten Unterhohlraum (105') füllt.

12. Vorrichtung (71; 81; 91; 101) nach einem der vorhergehenden Ansprüche, bei der das Widerstandsmaterial eine elektrische Leitfähigkeit zwischen 0,1 Ohm × Zentimeter und 10 Ohm × Zentimeter aufweist.

13. Vorrichtung (71; 81; 91; 101) nach einem der vorhergehenden Ansprüche, bei der die aktive Schicht (74; 140, 140') aus einem Metalloxid gebildet ist.

14. Verfahren zur Herstellung einer nichtflüchtigen Filamentspeichervorrichtung (71; 81; 91; 101), das die folgenden Schritte umfasst:

     - Aufbringen einer elektrisch isolierenden Abstandsschicht (76) auf eine erste Elektrode,
     - Ätzen, in der Abstandsschicht (76), eines Hohlraums (762) mit einem Boden (764), der aus einem Teil der ersten Elektrode (72) besteht, der nach dem Ätzen nicht mehr von der Abstandsschicht (76) bedeckt ist, wobei der Hohlraum mindestens eine Seitenfläche (763, 763') aufweist, die in der Abstandsschicht (76) den Hohlraum (762) seitlich abgrenzt,
     - Herstellen eines Nebenschlusswiderstands (R$_{//}$), der zumindest teilweise durch eine Schicht aus Widerstandsmaterial (75; 95; 105, 105') gebildet wird, die an der Seitenfläche (763, 763') des Hohlraums aufgebracht wird,
     - konformes Aufbringen einer aktiven Schicht (74; 140, 140'), die sich parallel zum Boden (764) des Hohlraums erstreckt und sich über die Schicht aus Widerstandsmaterial (75; 95; 105, 105') überlappend fortsetzt, wobei die aktive Schicht eine Dicke (e) von weniger als einem Drittel einer Dicke (h) der Abstandsschicht (76) hat,
     - Herstellen einer zweiten Elektrode (73; 103, 103'), die die Abstandsschicht (76) teilweise bedeckt und zumindest einen Teil des Hohlraums (762) ausfüllt, indem sie die aktive Schicht (74; 140, 140') bedeckt,

wobei die aktive Schicht (74; 140, 140'), die die erste Elektrode (72) mit der zweiten Elektrode (73; 103, 103') elektrisch verbindet und der Nebenschlusswiderstand (R$_{//}$) elektrisch parallel zur aktiven Schicht (74; 140, 140') zwischen der ersten Elektrode und der zweiten Elektrode geschaltet ist, wobei die Vorrichtung dazu bestimmt ist, aufzuweisen:

     - einen niederohmigen Zustand, in dem ein leitendes Filament (741; 141, 141'), das die erste Elektrode (72) mit der zweiten Elektrode (73; 103, 103') elektrisch verbindet, sich ununterbrochen durch die aktive Schicht erstreckt, wobei das Filament einen niedrigen elektrischen Widerstand (RL) hat, und
     - einen hochohmigen Zustand, in dem das Filament gerissen ist, wobei das Filament einen hohen elektrischen Widerstand (RH) hat.

15. Verfahren nach dem vorhergehenden Anspruch, das außerdem die folgenden Schritte umfasst, die nach der Herstellung des Nebenschlusswiderstands (R$_{//}$) und vor dem Aufbringen der aktiven Schicht (74; 140, 140') ausgeführt werden:

     - konformes Aufbringen einer Schicht aus dielektrischem Material (87; 107, 107'), wobei sich die Schicht parallel zum Boden (764) des Hohlraums erstreckt und parallel zur Seitenfläche (763, 763') des Hohlraums verläuft, wobei die Schicht aus dielektrischem Material die Schicht aus Widerstandsmaterial (75; 95; 105, 105') bedeckt,
     - Ätzen der Schicht aus dielektrischem Material, (87; 107, 107'), um den Teil dieser Schicht zu entfernen, der sich parallel zum Boden des Hohlraums (762) erstreckt.

**Claims**

1. Filament-type non-volatile memory device (71; 81; 91; 101), comprising a first electrode (72), a second electrode (73; 103, 103') and an active layer (74; 140, 140') extending between the first electrode and the second electrode, the active layer (74; 140, 140') electrically interconnecting the first electrode (72) to the second electrode (73; 103, 103'), the device being intended to have:

     - a low resistive state, in which a conducting filament (741; 141, 141') electrically interconnecting the first electrode (72) to the second electrode (73; 103, 103') uninterruptedly extends from end to end through the active layer, said filament having a low electric resistance (RL), and
     - a highly resistive state, in which said filament is broken, said filament having a high electric resistance (RH),

the device comprising a shunt resistance (R//) electrically connected in parallel to said active layer (74; 140, 140'), between the first electrode and the second electrode, in which:

- an electrically insulating spacer layer (76), partialy covers the first electrode (72), a cavity (762) being provided in this spacer layer, said cavity having a bottom (764), consisting of a part of the first electrode (72) which is not covered with the spacer layer, the cavity having at least one side face (763, 763') which, in the spacer layer (76), laterally delimits the cavity,

- the shunt resistance ($R_{//}$) is at least partialy formed of a resistive material layer (75; 95; 105, 105') applied against the side face of the cavity (763, 763'),

- the active layer (74; 140, 140') of the device extends parallel to the bottom (764) of the cavity and further extends by covering said resistive material layer (75; 95; 105, 105'), the active layer having a thickness (e) of less than a third of a thickness (h) of the spacer layer (76), and wherein

the second electrode (73; 103, 103') partialy covers the spacer layer (76) and fills at least part of said cavity (762), covering the active layer (74; 140, 140').

2. Device (71; 81; 91; 101) according to claim 1, wherein the active layer comprises a conducting filament (741; 141, 141'), which electrically interconnects the first electrode (72) to the second electrode (73; 103, 103'), the device having:

- a low resistive state, in which the conducting filament (741; 141, 141') uninterruptedly extends from end to end through the active layer, said filament having a low electric resistance (RL), and

- a highly resistive state, in which said filament is broken, said filament having a high electric resistance (RH),

said shunt resistance ($R_{//}$) being electrically connected in parallel to said filament (741; 141, 141'), between the first electrode and the second electrode.

3. Device (71; 81; 91; 101) according to the previous claim, wherein the shunt resistance ($R_{//}$) is lower than or equal to the high resistance of the filament ($R_H$).

4. Device (71; 81; 91; 101) according to any of claims 2 or 3, wherein the shunt resistance ($R_{//}$) is higher than or equal to the low resistance of the filament ($R_L$).

5. Device (71; 81; 91; 101) according to any of the previous claims, wherein the shunt resistance ($R_{//}$) is lower than 100 kiloOhms.

6. Device (71; 81; 91; 101) according to any of the previous claims, wherein the shunt resistance ($R_{//}$) is higher than 12.9 kiloOhms.

7. Device (81; 91; 101) according to one of the previous claims, wherein a layer (87; 107, 107') of dielectric material is interleaved between the active layer and said resistive material layer (75; 95; 105, 105').

8. Device (71; 81; 91; 101) according to the previous claim, wherein the active layer (74; 140, 140'), which extends from the first electrode (72) to the second electrode (73; 103, 103'), is laterally delimited by at least one side face (743, 743'; 143, 143'), and wherein the resistive material layer (75; 95; 105, 105'), which forms at least part of the shunt resistance ($R_{//}$), extends from the first electrode to the second electrode, in parallel to the side face (743, 743'; 143, 143') of the active layer.

9. Device (81; 91; 101) according to the previous claim, wherein the dielectric material layer (87; 107, 107') is interleaved between the side face (743, 743'; 143, 143') of the active layer and said resistive material layer (75; 95; 105, 105').

10. Device (91) according to one of the previous claims, wherein said resistive material layer (95) further extends on the bottom (764) of the cavity, between the active layer (74) and the bottom (764) of the cavity.

11. Device (101) according to one of the previous claims, further comprising:

- an electrically insulating block (108) which divides the cavity (762) into at least a first sub-cavity (765) and a second sub-cavity (765'), and

- a third electrode (103'), electrically insulated from the second electrode (103),

and wherein the second electrode (103) fills the first sub-cavity (105) whereas the third electrode (103') fills the second sub-cavity (105').

12. Device (71; 81; 91; 101) according to one of the previous claims, wherein said resistive material has an electric conductivity between 0.1 ohm $\times$ centimetre and 10 ohms $\times$ centimetres.

13. Device (71; 81; 91; 101) according to one of the previous claims, wherein the active layer (74; 140, 140') is formed by a metal oxide.

14. Method for manufacturing a filament-type non-volatile memory device (71; 81; 91; 101), comprising the following steps:

- depositing, onto a first electrode, an electrically insulating spacer layer (76),

- etching, in the spacer layer (76), a cavity (762) having a bottom (764), consisting of part of the first electrode (72) which, after etching, is no longer covered with the spacer layer (76), the cavity having at least one side face (763, 763') which, in the spacer layer (76), laterally delimits the cavity (762),

- making a shunt resistance ($R_{//}$), at least partialy formed by a layer (75; 95; 105, 105') of a resistive material deposited against the side face (763, 763') of the cavity,

- conformally depositing an active layer (74; 140, 140'), which extends in parallel to the bottom (764) of the cavity and which further extends by covering said resistive material layer (75; 95; 105, 105'), the active layer having a thickness (e) of less than a third of a thickness (h) of the spacer layer (76),

- making a second electrode (73; 103, 103') which partialy covers the spacer layer (76) and fills at least a part of said cavity (762), covering the active layer (74; 140, 140'),

the active layer (74; 140, 140') electrically interconnecting the first electrode (72) to the second electrode (73; 103, 103'), the shunt resistance ($R_{//}$) being electrically connected in parallel to said active layer (74; 140, 140'), between the first electrode and the second electrode, the device being iintended to have:

- a low resistive state, in which a conducting filament (741; 141, 141'), electrically interconnecting the first electrode (72) to the second electrode (73; 103, 103'), uninterruptedly extends from end to end through the active layer, said filament having a low electric resistance (RL), and

- a highly resistive state, in which said filament is broken, said filament having a high electric resistance (RH).

15. Method according to the previous claim, further comprising the following steps, carried out after having made the shunt resistance (R//), and before depositing the active layer (74; 140, 140'):

- conformally depositing a layer (87; 107, 107') of dielectric material, said layer extending parallel to the bottom (764) of the cavity and further extending parallel to the side face (763, 763') of the cavity, the dielectric material layer covering said resistive material layer (75; 95; 105, 105'),

- etching the dielectric material layer (87; 107, 107'), so as to remove the part of this layer which extends parallel to the bottom of the cavity (762).

**Fig. 1**

**Fig. 2**

Fig. 3

$R_{//}$ $R_H$ $\Longleftrightarrow$ $R_{TOT,H}$

Fig. 4

$R_{//}$ $R_L$ $\Longleftrightarrow$ $R_{TOT,L}$

Fig. 5

# Fig. 6

# Fig. 7

# Fig. 8

# Fig. 9

**EP 3 787 050 B1**

## RÉFÉRENCES CITÉES DANS LA DESCRIPTION

**Documents brevets cités dans la description**

- US 20110103131 A

- US 2005243596 A

**Littérature non-brevet citée dans la description**

- **GILBERT SASSINE et al.** Sub-pJ consumption and short latency time in RRAM arrays for high endurance applications. *IEEE International Reliability Physics Symposium (IRPS),* 2018